# FASCICULE DE BREVET EUROPEEN

(11) **EP 3 205 180 B1**
(45) Date de publication et mention de la délivrance du brevet: **19.02.2020**
(21) Numéro de dépôt: 15798493.1
(22) Date de dépôt: 07.10.2015
(51) Int. Cl.: H05B 3/84, B32B 17/10

(54) **VITRAGE CHAUFFANT ET DE BLINDAGE ELECTROMAGNETIQUE**
BEHEIZTE GLASPLATTE FÜR ELEKTROMAGNETISCHE ABSCHIRMUNG
HEATED GLASS PANEL FOR ELECTROMAGNETIC SHIELDING

(30) Priorité: 10.10.2014 FR 1459738
(43) Date de publication de la demande: 16.08.2017
(73) Titulaire: Saint-Gobain Glass France, 92400 Courbevoie (FR)
(72) Inventeur: TONDU, Thomas, F-45110 Saint Martin d'Abbat (FR); MAYEUX, Jean-Benoît, F-45800 Saint Jean de Braye (FR)
(74) Mandataire: Saint-Gobain Recherche
(86) Numéro de dépôt international: PCT/FR2015/052697
(87) Numéro de publication internationale: WO 2016/055735

(56) Documents cités:
- EP-A2- 0 281 278
- CN-U- 202 396 012
- FR-A1- 2 862 961
- US-A1- 2013 228 365

## Description

L'invention concerne un vitrage à fonctions de blindage électromagnétique et de chauffage.

L'invention sera plus particulièrement décrite en regard de ces applications, sans toutefois y être limitée.

Un vitrage chauffant est un vitrage comprenant des moyens électriquement conducteur sur l'une des faces du vitrage qui, lorsqu'ils sont soumis à un courant électrique, permet d'élever la température du vitrage. Ce type de vitrage trouve des applications dans les moyens de transport ou même le bâtiment, pour empêcher ou supprimer la formation de buée ou de givre sur le vitrage, ou encore supprimer la sensation de paroi froide à proximité du vitrage.

Les moyens électriquement conducteurs d'un vitrage chauffant sont de manière connue constitués par des fils métalliques sérigraphiés sur le verre ou incrustés dans les intercalaires de feuilletage, ou par des couches minces déposées sur le verre.

Un vitrage à blindage électromagnétique est un vitrage qui réduit la propagation d'ondes électromagnétiques à travers lui. Cette application trouve un intérêt dans le domaine électronique, notamment pour la réalisation de fenêtres de blindage électromagnétique, encore appelées filtres électromagnétiques, destinées par exemple à être disposées sur la face avant d'un écran de visualisation utilisant la technologie plasma. Une autre application concerne le domaine de l'aéronautique dont le besoin se fait sentir d'assurer la continuité du blindage électromagnétique d'un avion, afin que les téléphones portables et ordinateurs portables des passagers ne provoquent des perturbations qui gêneraient les liaisons entre les personnels de navigation et la tour de contrôle. Enfin, une autre application est celle de la limitation de la signature radar dans les domaines de l'aéronautique ou et la marine.

Le blindage électromagnétique est généralement réalisé à partir de couches minces ou de grilles métalliques, déposés sur le verre du vitrage ou toute autre interface telle que film intercalaire.

Il est connu de combiner sur le même vitrage les fonctions chauffantes et de blindage. Dans un tel vitrage, les moyens électriquement conducteurs pour le chauffage et les moyens conducteurs de blindage sont formés en combinaison, grâce par exemple à un empilement de couches minces dont la nature des matériaux déposés et leur épaisseur sont sélectionnées pour assurer les deux fonctions.

Le document CN 202 396 012 U décrit un vitrage à fonctions chauffante et de blindage électromagnétique, comportant un substrat en verre, un film conducteur chauffant déposé sur l'une des faces du substrat, un revêtement électriquement conducteur en périphérie du vitrage, pour le blindage électromagnétique. Cependant, le revêtement ne recouvre pas le film conducteur chauffant et le film conducteur n'est pas placé en périphérie du vitrage mais s'étend sur tout le vitrage.

Cependant, les vitrages précités présentent des inconvénients. Si les grilles métalliques sont efficaces au regard du blindage électromagnétique à basses fréquences, elles sont en revanche peu performantes au-delà de la dizaine de GHz. Or certaines applications demandent une performance significative, notamment une atténuation supérieure à 50 dB, voire même de l'ordre de 60 dB et plus, pour des fréquences de l'ordre ou supérieures à 10 GHz.

En outre, les grilles métalliques induisent de fortes dégradations optiques des vitrages, telles que des défauts de réfraction se traduisant par l'apparition de taches de diffraction de grande ampleur en cas d'observation de points lumineux (phares, feux...). Ou bien, en cas d'association de deux grilles métalliques, des effets de moirés peuvent également apparaitre lorsque l'on regarde au travers du vitrage. Or la qualité optique d'un vitrage est primordiale. Au regard de l'utilisation de couches minces, leur accumulation dégrade la transmission lumineuse des vitrages, et accroit le coût de fabrication. De plus, de tels vitrages connus, s'ils procurent de très bonnes propriétés de vision, ne permettent pas, par une unique couche transparente, conductrice, de conférer des atténuations meilleures que 40dB.

Enfin, on a pu montrer que si un vitrage doté de deux couches distinctes, une de chauffage et une de blindage électromagnétique en tant que tel espacées l'une de l'autre et isolées électriquement, peut procurer de bonnes performances à certaines fréquences, il est toujours souhaité d'améliorer encore les performances à d'autres fréquences, ne serait-ce qu'en parvenant à un gain de quelques dB.

L'invention a donc pour but de fournir un vitrage possédant les deux fonctions, de blindage électromagnétique et chauffage, procurant des atténuations supérieures à 40 dB pour une large gamme de fréquences, et même de l'ordre de 60 dB pour des fréquences supérieures à 10 GHz, tout en conférant de très bonnes propriétés de vision.

Selon l'invention, le vitrage à fonctions chauffante et de blindage électromagnétique, comportant au moins un substrat (tel qu'une feuille de verre ou un substrat en matière plastique), une couche chauffante déposée sur l'une des faces du substrat, et des moyens de blindage électromagnétique qui comprennent un revêtement électriquement conducteur sous la forme d'un revêtement métallique (de blindage) agencé en périphérie du vitrage, est caractérisé en ce que le revêtement métallique recouvre une partie périphérique de la couche chauffante, ladite couche chauffante étant isolée électriquement dudit revêtement par des moyens d'isolation électrique.

Lors de la fabrication du vitrage, d'autant plus lorsque la couche chauffante est faite à partir de dépôt d'argent, la couche chauffante est déposée sans s'étendre jusqu'au bord du substrat (sans s'étendre jusqu'au niveau de la tranche du substrat). Ainsi, la face du substrat comprenant la couche chauffante est dépourvue de couche chauffante au niveau de l'ensemble de sa périphérie. Généralement, la largeur (dimension transversale au côté du vitrage) du substrat exempte de couche chauffante est de l'ordre de 20 mm. Mais cette largeur peut atteindre localement plusieurs centimètres voire dizaines de centimètres pour les vitrages non rectangulaires (par exemple de forme trapézoïdale) et pourvue d'une couche chauffante de forme rectangulaire.

Avantageusement, le revêtement électriquement conducteur s'étend sur la totalité de la périphérie du vitrage, en recouvrant la couche chauffante avec en interface (selon l'épaisseur) les moyens d'isolation électrique.

Le revêtement de blindage métallique recouvre partiellement la couche chauffante en direction du centre du vitrage tout en étant isolé électriquement. Il s'étend depuis le bord du vitrage en direction du centre du vitrage, sur une distance limitée, notamment sur au plus 1 cm.

On entend par « recouvrir » au sens de l'invention, être en vis-à-vis dans des plans parallèles aux faces générales des substrats.

Le revêtement de blindage métallique est disposé au moins en partie à l'intérieur du vitrage. Il est agencé sur au moins l'une des faces internes du vitrage, sur au moins l'une des faces internes de l'un des substrats du vitrage.

Ainsi, pour un vitrage multiple, le revêtement de blindage métallique est disposé au moins en partie à l'intérieur du vitrage, sur au moins l'une des faces internes des substrats en verre du vitrage.

La couche chauffante en soi peut selon la nature de ses matériaux former également une partie des moyens de blindage électromagnétique. Néanmoins, de préférence, les moyens de blindage électromagnétique comprennent en outre une couche transparente de blindage électromagnétique distincte de la couche chauffante et isolée électriquement de celle-ci. Cette couche est par exemple, métallique du type à base d'argent, ou comprenant des matériaux semi-conducteurs tels que l'ITO (oxyde d'indium dopé à l'étain).

Selon l'invention, la présence du revêtement métallique électriquement conducteur formant partie des moyens de blindage électromagnétique du vitrage et son agencement sur le bord du vitrage, en particulier dans une zone dépourvue de ladite couche chauffante, et en recouvrement de la couche chauffante, tout en préservant un isolement électrique entre la couche chauffante et ledit revêtement, procurent des atténuations très significatives.

Des atténuations de l'ordre de 50, voire même 60 dB et plus, sont très avantageusement atteintes, aussi bien pour des basses fréquences de l'ordre de 5 MHz que pour des hautes fréquences, fréquences supérieures à 10 GHz.

Dans un mode de réalisation préféré, la couche chauffante recouvre la quasi-totalité du substrat hormis une zone périphérique par exemple d'environ 10 mm de large en limite du bord du vitrage. Le revêtement périphérique de blindage électromagnétique recouvre cette zone périphérique tout en préservant un isolement électrique entre la couche chauffante et ledit revêtement. Ainsi, la couche chauffante couvre de manière optimale la surface du vitrage, seul au moins le bord périphérique qui en est exempt, par exemple de quelques 10 mm, sont à recouvrir par le revêtement électro-conducteur selon l'invention.

Le revêtement électro-conducteur de l'invention peut être un revêtement opaque ou transparent. C'est un revêtement métallique. Il est par exemple en cuivre. Pour apposer ce revêtement sur le vitrage, le revêtement se présente par exemple sous la forme d'un adhésif.

En limitant la largeur du revêtement métallique électro-conducteur à la zone exempte de couche chauffante et à un recouvrement partiel de la couche chauffante (avec interface en épaisseur, électriquement isolante) - le recouvrement étant par exemple limité à environ 1 cm -, on ne dégrade pas le champ de vision du vitrage et on améliore de façon significative l'atténuation des ondes.

Avantageusement, le recouvrement de la couche chauffante par ledit revêtement électro-conducteur, selon la largeur en direction du centre du vitrage, est compris entre quelques millimètres quelques centimètres, en particulier est de l'ordre du centimètre.

Le vitrage comporte des moyens d'isolation électrique entre la couche chauffante et le revêtement électro-conducteur formant partie des moyens de blindage électromagnétique. Ces moyens d'isolation électrique sont par exemple en matière plastique, et se présentent sous la forme d'un ou plusieurs films intercalaires s'étendant sur toute la surface de la couche chauffante ou sont formés d'un film limité en largeur s'étendant depuis la tranche du vitrage et stoppant par recouvrement de la couche chauffante à distance de la tranche du vitrage. Le film intercalaire, limité en largeur est de préférence un adhésif.

On entend par « film », un moyen de séparation qui présente une plus faible épaisseur que l'épaisseur d'un substrat en verre.

L'épaisseur desdits moyens d'isolation électrique (dimension transversale à la surface générale du vitrage et dimension s'étendant selon l'épaisseur du vitrage) est de l'ordre du millimètre ou moins.

Les moyens d'isolation électrique recouvrent partiellement la couche chauffante en s'étendant vers l'intérieur du vitrage. La largeur d'étendue desdits moyens d'isolation électrique est au moins égale ou de préférence supérieure à la largeur de recouvrement du revêtement électro-conducteur. La largeur d'étendue desdits moyens d'isolation électrique est de l'ordre de 1,5 cm par exemple tandis que le revêtement électro-conducteur ne recouvre qu'une largeur de 1 cm.

Dans un exemple de réalisation, le vitrage comporte deux feuilles de verre et un intercalaire en matière plastique assemblant les deux feuilles de verre, et les moyens d'isolation électrique entre la couche chauffante et le revêtement électro-conducteur sont alors l'intercalaire en matière plastique séparant les deux feuilles de verre. L'intercalaire qui couvre la superficie du vitrage peut être mono ou multicouches, c'est-à-dire comprendre un film intercalaire ou un empilement de films.

De manière connue, un film intercalaire est par exemple en polyvinyle de butyral (PVB) et présente une épaisseur de 0,76 mm.

Dans un autre exemple de réalisation qui peut être préféré, les moyens d'isolation électrique en matière plastique sont un film adhésif mince de quelques dizaines de microns, en particulier de 20 µm. Ce film est collé sur la couche chauffante, et de préférence est limité en largeur entre une extrémité distale correspondant à la tranche du vitrage et son extrémité opposé stoppée à au plus quelques centimètres du bord.

Selon une caractéristique, les moyens de blindage électromagnétique comprennent en outre une couche de blindage électromagnétique en tant que tel (qui est couche électriquement conductrice, en particulier en métal ou en matériaux semi-conducteurs), qui est déposée sur une autre face du substrat que la face portant la couche chauffante ou sur un autre substrat que celui portant la couche chauffante si le vitrage comporte plusieurs substrats.

Tel que déjà exprimé plus haut, si la couche chauffante ne recouvre pas usuellement la totalité du substrat, il est néanmoins préférable qu'elle soit déposée sur la quasi-totalité de la surface à l'exception des quelques millimètres périphériques de manière à minimiser l'étendue du revêtement électro-conducteur de blindage électromagnétique dans la zone de vision du vitrage. Il est également préférable de minimiser la résistance chauffante de la couche chauffante et augmenter ainsi le gain d'atténuation.

La nature de la couche chauffante et la nature de la couche de blindage électromagnétique lorsque cette dernière est présente, seront avantageusement optimisées afin de réduire au mieux la résistance (surfacique) par carré de chaque couche. Les vitrages usuelles comprennent des couches chauffantes et/ou de blindage dont chaque couche présente une résistance totale au moins inférieure à 10 Ω/□, de préférence inférieure à 2 Ω/□ voire même inférieure à 1 Ω/□.

De plus, lorsqu'une couche de blindage électromagnétique en tant que tel est ajoutée à la couche chauffante, les deux couches de blindage et chauffante sont espacées selon une épaisseur établie pour optimiser le blindage. Cette épaisseur d'isolation électrique est par exemple de l'ordre de quelques millimètres à quelques centimètres selon la nature des matériaux isolants (verre ou matière plastique ou gaz).

Dans un mode de réalisation préféré du vitrage, celui-ci comporte au moins deux feuilles de verre et un intercalaire séparant les deux feuilles de verre, cet intercalaire pouvant être une lame de gaz et/ou une feuille de matière plastique du type en PVB, une couche chauffante et le revêtement électro-conducteur de blindage électromagnétique, et une couche de blindage électromagnétique, la couche de blindage électromagnétique étant associée à l'une des feuilles de verre et agencée entre les deux feuilles de verre, tandis que la couche chauffante est déposée sur l'autre feuille de verre et sur la face extérieure opposée à celle associée à l'intercalaire. La couche chauffante associée au revêtement électro-conducteur de blindage électromagnétique peut être recouverte d'un film protecteur de protection en matière plastique, ou d'une couche mince de protection connue en soi, ou encore être prise en feuilleté avec une troisième feuille de verre.

Le vitrage peut avoir diverses applications dans le domaine du blindage électromagnétique. Il est par exemple utilisé dans les domaines de l'aéronautique, la marine, les véhicules terrestres (camion, bus, voiture, char, etc.) ou dans le bâtiment.

La présente invention est maintenant décrite à l'aide d'exemples uniquement illustratifs et nullement limitatifs de la portée de l'invention, et à partir des illustrations ci-jointes, dans lesquelles :
- La figure 1 représente une vue partielle en coupe transversale d'un exemple de réalisation de vitrage selon l'invention;
- La figure 2 est vue en coupe et agrandie d'une partie de la figure 1, montrant le revêtement périphérique de blindage électromagnétique et la couche chauffante ;
- Les figures 3a à 3c illustrent les étapes de fabrication d'une variante de réalisation du vitrage de l'invention ;
- La figure 4 illustre des courbes d'atténuation de deux exemples de vitrage de l'invention et de deux exemples comparatifs.

Les dessins ne sont pas à l'échelle pour en faciliter la lecture.

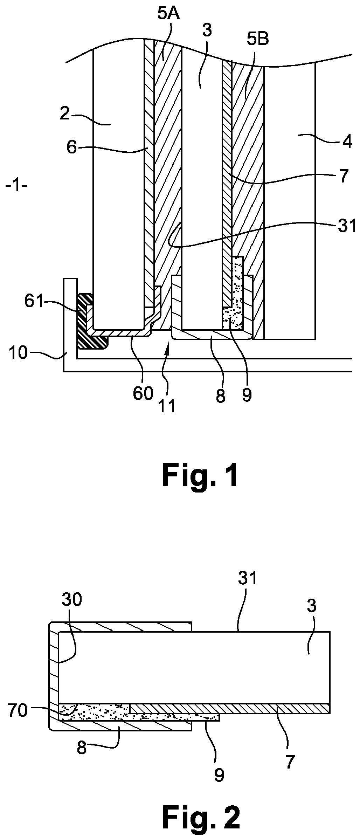

La figure 1 illustre un vitrage 1 chauffant et de blindage électromagnétique selon l'invention.

A titre d'exemple nullement limitatif, le vitrage 1 est un vitrage feuilleté et comporte trois substrats sous forme de feuilles de verre 2, 3 et 4 assemblées de manière connue par deux intercalaires en matière plastique du type PVB, respectivement 5A et 5B, une couche usuelle de blindage électromagnétique 6 ayant en tant que telle la fonction de blindage électromagnétique (ayant une résistance par carré au moins inférieure à 10 Ω/□, voire même inférieure à 2 Ω/□), une couche chauffante 7 (ayant une résistance par carré au moins inférieure à 10 Ω/□, voire même inférieure à 2 Ω/□) pouvant former des moyens de blindage électromagnétique car pouvant par la nature de ses matériaux participer à la fonction de blindage électromagnétique, et selon l'invention un revêtement électriquement conducteur 8 formant partie des moyens de blindage électromagnétique.

Le vitrage pourrait être un vitrage thermiquement isolant, les feuilles de verre étant alors séparées par des lames de gaz. Le vitrage isolant pourrait également comprendre des films en matière plastique.

Selon la nature du vitrage et le type de fonctions à apporter au vitrage, le nombre de substrats et les moyens intercalaires seront adaptés. Les substrats ici décrits sont en verre, mais ils pourraient être en matière plastique, tel qu'en PMMA (polyméthacrylate de méthyle) ou PC (polycarbonate).

Pour assurer la fonction de blindage électromagnétique, le vitrage comporte donc la couche conductrice électriquement 6 recouvrant l'une des faces d'une des feuilles de verre, de préférence, la face (2) du vitrage.

On rappelle que les faces d'un vitrage feuilleté doté de deux substrats verriers sont conventionnellement numérotées (1), (2), (3), (4) en partant de l'environnement extérieur du vitrage vers l'intérieur d'un habitacle lorsque le vitrage est monté dans une baie fermant ledit habitacle.

La couche de blindage 6 est un revêtement transparent électro-conducteur tel qu'une couche mince à base d'ITO (oxyde d'indium dopé à l'étain) ou d'argent.

La couche de blindage 6 est raccordée électriquement au châssis électriquement conducteur 10 du cadre dans lequel est logé le vitrage. Le cadre 10 est destiné à être rapporté dans la baie de l'habitacle à fermer par un vitrage. La connexion électrique entre la couche de blindage 6 et le cadre 10 est de manière connue effectuée par exemple par un adhésif de raccordement électrique 60 collé sur la couche et rabattu sur le substrat verrier 2 ainsi qu'un joint électriquement conducteur 61 assurant la liaison électrique entre l'adhésif 60 et le cadre métallique 10.

Pour assurer la fonction de chauffage, le vitrage comporte une couche chauffante 7 déposée à distance de la couche de blindage 6, et de préférence agencée sur la face (4) du vitrage. La couche chauffante 7 est de préférence faite à partir d'argent ou d'ITO.

La couche chauffante 7 est usuellement protégée. Selon le type de vitrage, comme dans l'exemple illustré, le vitrage comporte un troisième substrat 4 feuilleté avec le deuxième substrat 3, la couche 7 étant protégée par le film intercalaire 5B. Dans des variantes de configuration du vitrage, le vitrage pourrait ne comprendre que deux substrats, la couche chauffante 7 étant alors protégée par un film protecteur de revêtement en matière plastique ou par le dépôt d'une couche mince de protection connue en soi et qui n'est pas électriquement conductrice. La couche de protection anti-rayure précitée ne sera utilisée que si la couche chauffante du vitrage est uniquement alimentée en basse tension.

De préférence, la couche chauffante 7 recouvre l'ensemble de la face verrière du substrat 3. Néanmoins, comme usuellement pour le dépôt de couches minces, la couche chauffante ne s'étend pas jusqu'au bord du vitrage, c'est-à-dire jusqu'au niveau de la tranche 11 du vitrage.

Selon l'invention, le vitrage comporte des moyens de blindage électromagnétique supplémentaires 8.

Ces moyens de blindage électromagnétique supplémentaires 8 sont associés à la couche chauffante 7 en étant isolés électriquement de celle-ci par des moyens d'isolation 9.

Ces moyens de blindage électromagnétique supplémentaires 8 sont faits d'un revêtement métallique tel qu'un adhésif électriquement conducteur, par exemple en cuivre.

En regard de la vue de détail de la figure 2, le revêtement 8 est disposé en regard de la couche 7 et recouvre ladite couche, tout en étant séparé de celle-ci par les moyens isolants 9.

Dans l'exemple de réalisation illustré, d'une part le revêtement 8 s'étend sur la couche chauffante en la recouvrant partiellement en direction du centre du vitrage, en particulier de l'ordre d'un centimètre, et d'autre part, il court jusqu'à la tranche 30 de la feuille de verre 3, la coiffe et recouvre partiellement la face (3) du vitrage correspondant à la face opposée de la face portant la couche chauffante 7. Le recouvrement de la face (3) s'étend en vis-à-vis du recouvrement de la couche chauffante 7 et est limité à la largeur de ce dernier. Le revêtement 8 présente une forme en U dans cet exemple.

Selon l'invention, il importe qu'en regard de la zone 70 de la face (4) du vitrage portant la couche chauffante 7, zone exempte de couche chauffante, les moyens de blindage électromagnétique supplémentaires 8 puissent recouvrir cette zone même avec la présence d'une interface isolante 9.

Dans des variantes de réalisation, les moyens de blindage électromagnétique supplémentaires (revêtement électro-conducteur) 8 pourraient ne s'étendre que jusqu'au bord du vitrage, à la limite de la tranche 30, et/ou ne pas couvrir la face du substrat opposée à celle portant la couche chauffante 7.

Le revêtement métallique 8 formant les moyens de blindage électromagnétique supplémentaires n'est pas nécessairement relié électriquement ni à la couche de blindage électromagnétique 6, ni au cadre métallique du vitrage.

En outre, il est impératif que les moyens de blindage électromagnétique supplémentaires 8 qui sont électriquement conducteurs ne soient pas en contact direct avec la couche chauffante 7. C'est pourquoi, les moyens d'isolation électrique 9 sont interposés entre la couche chauffante 7 et le revêtement métallique 8.

Dans l'exemple de réalisation présenté, ces moyens d'isolation électrique 9 sont formés d'un mince adhésif en polytéréphtalate d'éthylène (PET) de 20 µm. Ils s'étendent sur la couche chauffante selon une largeur au moins aussi longue que le revêtement 8. Ils s'arrêtent au bord de la tranche 30 de la feuille de verre 3.

La fabrication du vitrage illustré est le suivant :
- les couches de blindage 6 et chauffante 7 ont été préalablement déposées sur les substrats verriers qui ne sont pas encore assemblés ;
- l'adhésif isolant en PET 9 est déposé sur la couche chauffante 7 ;
- le revêtement conducteur 8 est déposé sur l'adhésif isolant 9 ; c'est un adhésif en cuivre qu'on colle sur l'adhésif 9, la tranche 30 de la feuille de verre et la face opposée 31 de la feuille de verre ;
- on assemble en autoclave les deux feuilles de verre 2 et 3 ainsi que la troisième feuille de verre avec les feuilles de PVB 5A et 5B.

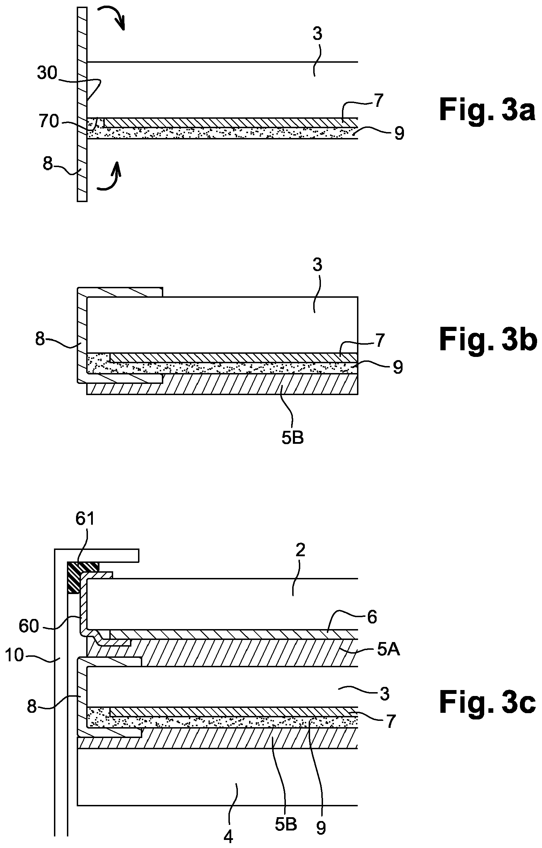

Dans une variante de réalisation illustrée sur la figure 3c, quant à la nature des moyens d'isolation 9, ces derniers sont formés par un ou plusieurs films intercalaires qui s'étendent sur toute la superficie de la couche chauffante 7.

Plus particulièrement, le procédé de fabrication est le suivant.

En regard de la figure 3a, sur le deuxième substrat verrier 3 portant la couche chauffante 7, un film intercalaire 9 a été solidarisé. Puis l'adhésif électro-conducteur 8 est collé sur la tranche 30 du substrat 3. L'adhésif électro-conducteur 8 est rabattu selon les flèches sur les deux faces du substrat 3.

Une fois rabattu tel qu'illustré sur la figure 3b, l'adhésif électro-conducteur 8, est recouvert du côté de la couche chauffante 7 par le film intercalaire 5B.

Enfin, en regard de la figure 3c, le deuxième substrat 3 est solidarisé d'une part, via le film intercalaire 5A avec le premier substrat 2 sur lequel a été déposé la couche de blindage électromagnétique 6, et d'autre part avec le troisième substrat 4 via le film intercalaire 5B.

Les films intercalaire 5A et 5B en matière plastique peuvent être mono ou multicouches.

Le vitrage de l'invention procure des résultats remarquables quant à l'atténuation des ondes électromagnétiques et des propriétés optiques également excellente avec un taux de transmission lumineuse (TL) supérieur à 70% et une absence de diffraction.

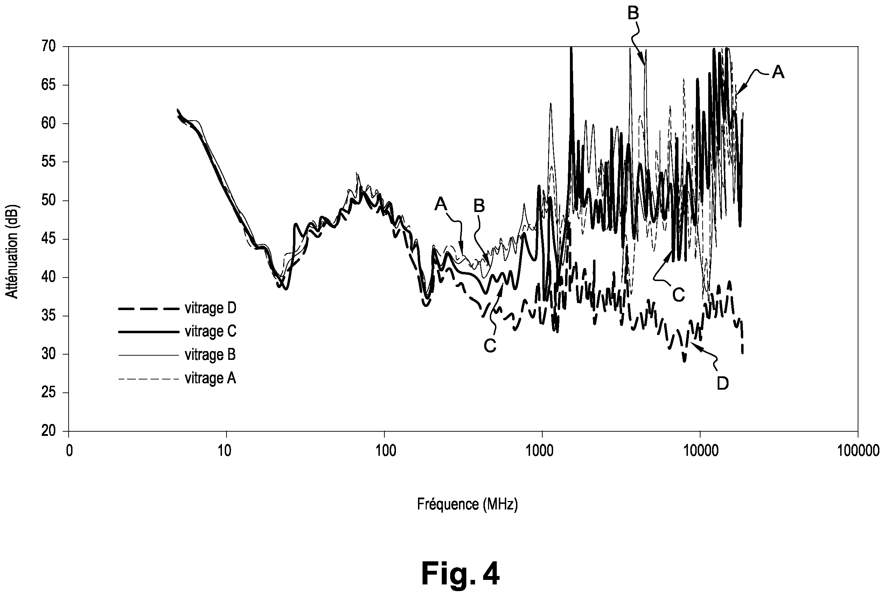

La figure 4 illustre des courbes d'atténuation en dB pour trois vitrages :
- Un vitrage A de l'invention qui est celui décrit plus haut selon le premier exemple de réalisation au regard des moyens isolants 9. Le vitrage A comporte des substrats verriers 2, 3 et 4 de 4 mm d'épaisseur et deux intercalaires en PVB, respectivement 5A de 1,52 mm et 5B de 3,04 mm, une couche usuelle de blindage 6 une couche chauffante usuelle 7, ainsi que selon l'invention un adhésif 8 en cuivre ici de 50 µm d'épaisseur et s'étendant en regard de la couche chauffante sur une largeur de 1 cm, et des moyens isolants 9 formés par un adhésif en PET de 20 µm.
- Un vitrage B présentant les mêmes caractéristiques que le vitrage A hormis que les moyens isolants 9 sont formés par un film intercalaire de 1,52 mm d'épaisseur.
- Un vitrage comparatif C identique aux vitrages A et B (au regard de l'emplacement et de la nature des couches chauffante et de blindage électromagnétique), toutefois dépourvus du revêtement de blindage 8 et des moyens isolants 9.
- Un vitrage comparatif D ne comprenant qu'une couche de blindage électromagnétique identique à celle présente dans les vitrages A, B et C, agencée entre deux substrats verriers de 4 mm d'épaisseur et assemblés par un film intercalaire de 1,52 mm.

Les mesures d'atténuation ont été faites selon la norme GAM T20 (Septembre 1992).

Le vitrage D (courbe la plus inférieure) ne comprenant que la seule couche de blindage électromagnétique est significativement moins performant que les autres vitrages. En outre, pour les fréquences à partir de 200 MHz (courbe la plus inférieure), l'atténuation procurée est inférieure à 40dB.

Le vitrage C permet de montrer que la couche chauffante qui est une couche à base de matériaux conducteurs tels que l'ITO participe aussi au blindage électromagnétique. On constate ainsi que l'atténuation est plus importante que pour le vitrage D. Cependant, l'atténuation reste inférieure ou sensiblement inférieure à l'atténuation procurée par les deux vitrages A et B de l'invention pour l'ensemble du spectre des fréquences, que ce soit entre 10 et 200 MHz, ou entre 200 et 10 000 MHz ou au-delà de 10 GHz.

Pour les fréquences en-dessous de 200 MHz ou comprises, entre 200 et 1000 MHz, même si le gradient d'atténuation est de quelques dB (1 à 5 dB) entre le vitrage comparatif C et les vitrages A et B, ces quelques dB de gain grâce au revêtement périphérique de blindage selon l'invention sont très significatifs pour certaines applications.

Pour les fréquences supérieures à 1000 MHz (1 GHz) et même les hautes fréquences supérieures à 10 GHz, on obtient avec les vitrages A et B de l'invention des atténuations supérieures à 50 dB, et même des valeurs supérieures à 60 dB.

Si l'atténuation procurée par le vitrage C est assez proche de celle des vitrages de l'invention pour les fréquences supérieures à 1 GHz, l'atténuation du vitrage C reste pour la plupart de ces fréquences en-dessous de celle des vitrages A et B (de l'ordre de 1 à 3 dB).

Les vitrages de l'invention répondent ainsi aux performances à atteindre sur la très la rage gamme de fréquences de 10 MHz à plus de 10 GHz :
- une atténuation supérieure à 40 dB pour la gamme précitée des fréquences,
- une atténuation supérieure à 45 dB pour les fréquences entre 30 MHz et 150 MHz et au-delà de 500 MHz,
- une atténuation supérieure à 50 dB pour les fréquences au-delà de 1 GHz, de l'ordre en moyenne de 55 dB,
- une atténuation comprise entre 55 et 65 dB pour les fréquences au-delà de 10 GHz,
- un gain d'atténuation qui peut être jusqu'à de l'ordre de 5 dB au regard du vitrage C doté des couches chauffante et de blindage, et de plus de 5dB, voire de l'ordre de 10 dB au regard du vitrage D doté de la seule couche de blindage électromagnétique.

## Revendications

1. Vitrage à fonctions chauffante et de blindage électromagnétique, comportant au moins un substrat (3), une couche chauffante (7) déposée sur l'une des faces du substrat, et des moyens de blindage électromagnétique qui comprennent un revêtement électriquement conducteur (8) sous la forme d'un revêtement métallique agencé en périphérie du vitrage, **caractérisé en ce que** le revêtement métallique (8) recouvre une partie de la couche chauffante (7), ladite couche chauffante étant isolée électriquement dudit revêtement par des moyens d'isolation électrique (9).

2. Vitrage selon la revendication 1, **caractérisé en ce que** le revêtement électriquement conducteur (8) s'étend sur la totalité de la périphérie du vitrage en recouvrant la couche chauffante (7) avec en interface les moyens d'isolation électrique (9).

3. Vitrage selon la revendication 1 ou 2, **caractérisé en ce que** la couche chauffante (7) recouvre la quasi-totalité du substrat hormis une zone périphérique (70) en limite du bord du vitrage, le revêtement électriquement conducteur (8) recouvrant cette zone périphérique (70) tout en préservant un isolement électrique entre la couche chauffante et ledit revêtement électriquement conducteur.

4. Vitrage selon l'une quelconque des revendications précédentes, **caractérisé en ce que** le revêtement métallique (8) est opaque, tel qu'à base de cuivre.

5. Vitrage selon l'une quelconque des revendications précédentes, **caractérisé en ce que** le revêtement électriquement conducteur (8) se présente sous la forme d'un adhésif.

6. Vitrage selon l'une quelconque des revendications précédentes, **caractérisé en ce que** la couche chauffante (7) forme une partie des moyens de blindage électromagnétique.

7. Vitrage selon l'une quelconque des revendications précédentes, **caractérisé en ce que** les moyens de blindage électromagnétique comprennent une couche de blindage électromagnétique (6) distincte de la couche chauffante (7) et isolée électriquement de celle-ci.

8. Vitrage selon l'une quelconque des revendications précédentes, **caractérisé en ce que** les moyens d'isolation électrique (9) entre la couche chauffante (7) et le revêtement électriquement conducteur (8) sont en matière plastique.

9. Vitrage selon l'une quelconque des revendications précédentes, **caractérisé en ce que** les moyens d'isolation électrique (9) sont en une matière électriquement isolante, telle qu'en matière plastique, et sont formés d'un ou plusieurs films intercalaires s'étendant sur toute la surface de la couche chauffante (7) ou sont formés d'un film limité en largeur s'étendant depuis la tranche du vitrage et stoppant par recouvrement de la couche chauffante à distance de la tranche du vitrage, de préférence le film limité en largeur étant un adhésif.

10. Vitrage selon l'une quelconque des revendications précédentes, **caractérisé en ce que** la largeur d'étendue des moyens d'isolation électrique (9) est au moins égale ou de préférence supérieure à la largeur de recouvrement dudit revêtement électriquement conducteur (8) de blindage électromagnétique.

11. Vitrage selon l'une quelconque des revendications précédentes, **caractérisé en ce que** les moyens de blindage électromagnétique comportent une couche de blindage électromagnétique (6) électriquement conductrice qui est déposée sur une autre face du substrat que la face portant la couche chauffante (7) ou sur un autre substrat que celui portant la couche chauffante si le vitrage comporte plusieurs substrats.

12. Vitrage selon l'une quelconque des revendications précédentes, **caractérisé en ce qu'**il comporte au moins deux feuilles de verre (2, 3) et un intercalaire (5A) séparant les deux feuilles de verre, ledit intercalaire (5A) pouvant être une lame de gaz et/ou une feuille de matière plastique du type en PVB, la couche chauffante (7) et le revêtement électro-conducteur (8) de blindage électromagnétique, et une couche de blindage électromagnétique (6), la couche de blindage électromagnétique (6) étant associée à l'une des feuilles de verre (2) et agencés entre les deux feuilles de verre, tandis que la couche chauffante (7) est déposée sur l'autre feuille de verre (3) et sur la face extérieure opposée à celle associée à l'intercalaire (5A).

13. Vitrage selon la revendication précédente, **caractérisé en ce que** la couche chauffante (7) est recouverte d'un film protecteur de protection en matière plastique (5B), ou d'une couche mince de protection, ou encore est prise en feuilleté avec une troisième feuille de verre (4).

14. Utilisation d'un vitrage selon l'une quelconque des revendications précédentes dans le domaine de l'aéronautique, la marine, les véhicules terrestres ou dans le bâtiment.

## Patentansprüche

1. Verglasung mit Heizfunktion und Funktion der elektromagnetischen Abschirmung, umfassend mindestens ein Substrat (3), eine heizende Schicht (7), die auf eine der Seiten des Substrats aufgebracht ist, und Mittel zur elektromagnetischen Abschirmung, die einen elektrisch leitenden Überzug (8) in Form eines Metallüberzugs umfassen, der am Umfang der Verglasung angeordnet ist, **dadurch gekennzeichnet, dass** der Metallüberzug (8) einen Teil der heizenden Schicht (7) bedeckt, wobei die heizende Schicht vom Überzug durch Mittel zur elektrischen Isolation (9) elektrisch isoliert ist.

2. Verglasung nach Anspruch 1, **dadurch gekennzeichnet, dass** sich der elektrisch leitende Überzug (8) über den gesamten Umfang der Verglasung erstreckt und dabei die heizende Schicht (7) überzieht, mit an der Grenzfläche den Mitteln zur elektrischen Isolation (9).

3. Verglasung nach Anspruch 1 oder 2, **dadurch gekennzeichnet, dass** die heizende Schicht (7) fast das gesamte Substrat bis auf einen Umfangsbereich (70) am äußersten Rand der Verglasung überzieht, wobei die elektrisch leitende Schicht (8) diesen Umfangsbereich (70) überzieht und dabei eine elektrische Isolation zwischen der heizenden Schicht und dem elektrisch leitenden Überzug aufrechterhält.

4. Verglasung nach einem der vorhergehenden Ansprüche, **dadurch gekennzeichnet, dass** der Metallüberzug (8) opak ist, beispielsweise auf der Basis von Kupfer.

5. Verglasung nach einem der vorhergehenden Ansprüche, **dadurch gekennzeichnet, dass** der elektrisch leitende Überzug (8) in Form eines Haftmittels vorliegt.

6. Verglasung nach einem der vorhergehenden Ansprüche, **dadurch gekennzeichnet, dass** die heizende Schicht (7) einen Teil der Mittel zur elektromagnetischen Abschirmung bildet.

7. Verglasung nach einem der vorhergehenden Ansprüche, **dadurch gekennzeichnet, dass** die Mittel zur elektromagnetischen Abschirmung eine Schicht zur elektromagnetischen Abschirmung (6) umfassen, die von der heizenden Schicht (7) verschieden ist und von dieser elektrisch isoliert ist.

8. Verglasung nach einem der vorhergehenden Ansprüche, **dadurch gekennzeichnet, dass** die Mittel zur elektrischen Isolation (9) zwischen der heizenden Schicht (7) und dem elektrisch leitenden Überzug (8) aus Kunststoff sind.

9. Verglasung nach einem der vorhergehenden Ansprüche, **dadurch gekennzeichnet, dass** die Mittel zur elektrischen Isolation (9) aus einem elektrisch isolierenden Material sind, beispielsweise aus Kunststoff, und aus einem oder mehreren Zwischenschichtfilmen gebildet sind, die sich über die gesamte Fläche der heizenden Schicht (7) erstrecken, oder aus einem in der Breite begrenzten Film gebildet sind, der sich von der Schmalseite der Verglasung aus erstreckt und durch Überdeckung der heizenden Schicht im Abstand von der Schmalseite der Verglasung stoppt, wobei der in der Breite begrenzte Film bevorzugt ein Haftmittel ist.

10. Verglasung nach einem der vorhergehenden Ansprüche, **dadurch gekennzeichnet, dass** die Ausdehnungsbreite der Mittel zur elektrischen Isolation (9) mindestens gleich der oder bevorzugt größer als die Überdeckungsbreite des elektrisch leitenden Überzugs (8) zur elektromagnetischen Abschirmung ist.

11. Verglasung nach einem der vorhergehenden Ansprüche, **dadurch gekennzeichnet, dass** die Mittel zur elektromagnetischen Abschirmung eine elektrisch leitende Schicht zur elektromagnetischen Abschirmung (6) umfassen, die auf eine andere Seite des Substrats aufgebracht ist als die Seite, welche die heizende Schicht (7) trägt, oder auf ein anderes Substrat als das, das die heizende Schicht trägt, wenn die Verglasung mehrere Substrate umfasst.

12. Verglasung nach einem der vorhergehenden Ansprüche, **dadurch gekennzeichnet, dass** sie mindestens zwei Glasscheiben (2, 3) und eine Zwischenschicht (5A), die die Glasscheiben trennt, umfasst, wobei die Zwischenschicht (5A) eine Gasfüllung und/oder eine Kunststofffolie vom PVB-Typ, die heizende Schicht (7) und der elektrisch leitende Überzug (8) zur magnetischen Abschirmung, und eine Schicht zur elektromagnetischen Abschirmung (6) sein kann, wobei die Schicht zur elektromagnetischen Abschirmung (6) einer der Glasscheiben (2) zugeordnet ist und zwischen den beiden Glasscheiben angeordnet ist, während die heizende Schicht (7) auf die andere Glasscheibe (3) und auf die Außenseite, die entgegengesetzt zu derjenigen ist, die der Zwischenschicht (5A) zugeordnet ist, aufgebracht ist.

13. Verglasung nach dem vorhergehenden Anspruch, **dadurch gekennzeichnet, dass** die heizende Schicht (7) mit einem schützenden Schutzfilm aus Kunststoff (5B) oder einer dünnen Schutzschicht bedeckt ist oder mit einer dritten Glasscheibe (4) zu Verbundglas laminiert ist.

14. Verwendung einer Verglasung nach einem der vorhergehenden Ansprüche im Bereich der Luftfahrt, der Schifffahrt, der Landfahrzeuge oder im Hochbau.

## Claims

1. Glazing unit providing heating and electromagnetic shielding functions, including at least one substrate (3), a heating layer (7) deposited on one of the faces of the substrate, and electromagnetically shielding means that comprise an electrically conductive coating (8) taking the form of a metal coating arranged on the periphery of the glazing unit, **characterized in that** the metal coating (8) covers a portion of the heating layer (7), said heating layer being electrically insulated from said coating by electrically insulating means (9).

2. Glazing unit according to Claim 1, **characterized in that**, with the electrically insulating means (9) intermediate, the electrically conductive coating (8) covers the heating layer (7) and extends right round the periphery of the glazing unit.

3. Glazing unit according to Claim 1 or 2, **characterized in that** the heating layer (7) covers almost all of the substrate except for a peripheral zone (70) at the very edge of the glazing unit, the electrically conductive coating (8) covering this peripheral zone (70) while nonetheless remaining electrically insulated from the heating layer.

4. Glazing unit according to any one of the preceding claims, **characterized in that** the metal coating (8) is opaque and for example based on copper.

5. Glazing unit according to any one of the preceding claims, **characterized in that** the electrically conductive coating (8) takes the form of an adhesive.

6. Glazing unit according to any one of the preceding claims, **characterized in that** the heating layer (7) forms a portion of the electromagnetically shielding means.

7. Glazing unit according to any one of the preceding claims, **characterized in that** the electromagnetically shielding means comprise an electromagnetically shielding layer (6) separate from the heating layer (7) and electrically insulated therefrom.

8. Glazing unit according to any one of the preceding claims, **characterized in that** the electrically insulating means (9) between the heating layer (7) and the electrically conductive coating (8) are made of plastic.

9. Glazing unit according to any one of the preceding claims, **characterized in that** the electrically insulating means (9) are made of an electrical insulator, such as a plastic, and are formed from one or more interlayer films extending right over the heating layer (7) or are formed from a film of limited width extending from the edge face of Glazing unit and stopping so as to cover the heating layer a distance away from the edge face of Glazing unit, the film of limited width preferably being an adhesive.

10. Glazing unit according to any one of the preceding claims, **characterized in that** the widthwise extent of the electrically insulating means (9) is at least equal to or preferably larger than the widthwise coverage of said electromagnetically shielding, electrically conductive coating (8).

11. Glazing unit according to any one of the preceding claims, **characterized in that** the electromagnetically shielding means include an electrically conductive electromagnetically shielding layer (6) that is deposited on a face of the substrate other than the face bearing the heating layer (7) or on a substrate other than that bearing the heating layer if Glazing unit includes a plurality of substrates.

12. Glazing unit according to any one of the preceding claims, **characterized in that** it includes at least two glass sheets (2, 3) and an interlayer (5A) separating the two glass sheets, said interlayer (5A) possibly being a gas-filled cavity and/or a sheet of plastic of the type made of PVB, the heating layer (7) and the electromagnetically shielding electrically conductive coating (8), and an electromagnetically shielding layer (6), the electromagnetically shielding layer (6) being associated with one of the glass sheets (2) and arranged between the two glass sheets, whereas the heating layer (7) is deposited on the other glass sheet (3) and on the exterior face opposite that associated with the interlayer (5A).

13. Glazing unit according to the preceding claim, **characterized in that** the heating layer (7) is covered with a protective protecting film (5B) made of plastic, or with a thin protective layer, or even is laminated with a third glass sheet (4).

14. Use of a glazing unit according to any one of the preceding claims, in the aeronautical, nautical, terrestrial automotive, or architectural fields.
